**Europäisches Patentamt**

(19) **European Patent Office**

**Office européen des brevets**

(11) Numéro de publication: **0 062 572**

**B1**

(12) **FASCICULE DE BREVET EUROPÉEN**

(45) Date de publication du fascicule du brevet: **15.10.86**

(21) Numéro de dépôt: **82400554.0**

(22) Date de dépôt: **26.03.82**

(51) Int. Cl.⁴: **H 03 K 17/96**

(54) **Clavier capacitif à structure antiparasite.**

(30) Priorité: **03.04.81 FR 8106757**
**03.04.81 FR 8106758**

(43) Date de publication de la demande:
**13.10.82 Bulletin 82/41**

(45) Mention de la délivrance du brevet:
**15.10.86 Bulletin 86/42**

(84) Etats contractants désignés:
**BE CH DE FR GB IT LI NL**

(56) Documents cité:
**DE-A-2 333 260**
**DE-A-2 746 655**
**DE-A-2 822 847**
**FR-A-2 326 083**
**FR-A-2 397 696**
**US-A-3 815 127**
**US-A-4 145 748**

(73) Titulaire: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Audoin, Marcel, 156, Avenue Victor Hugo, F-38170 Seyssinet (FR)**
Inventeur: **Fedeli, Jean- Marc, Beauséjour Bat. G4 - Le Fontanil, F-38120 Saint Egreve (FR)**
Inventeur: **Poujois, Robert, Le Jaillet, F-38650 Sinard (FR)**

(74) Mandataire: **Mongrédien, André, c/o BREVATOME 25, rue de Ponthieu, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention se rapporte aux claviers capacitifs grâce auxquels on peut obtenir, par la présence d'un doigt sur une touche sensible, l'exécution d'un ordre déterminé. De tels claviers sont de plus en plus utilisés tant pour les applications industrielles et scientifiques que dans les lieux ouverts au grand public et même dans les appareils électro-ménagers.

On commencera d'abord, pour situer les différents problèmes que résout l'invention, par rappeler le fonctionnement connu d'un tel clavier capacitif. Les claviers capacitifs statiques utilisent d'une façon générale le fait que la présence du doigt d'un utilisateur au voisinage d'une ou de plusieurs armatures conductrices crée des capacités électriques entre ce doigt et ces armatures et modifie ainsi les capacités existantes entre ces mêmes armatures.

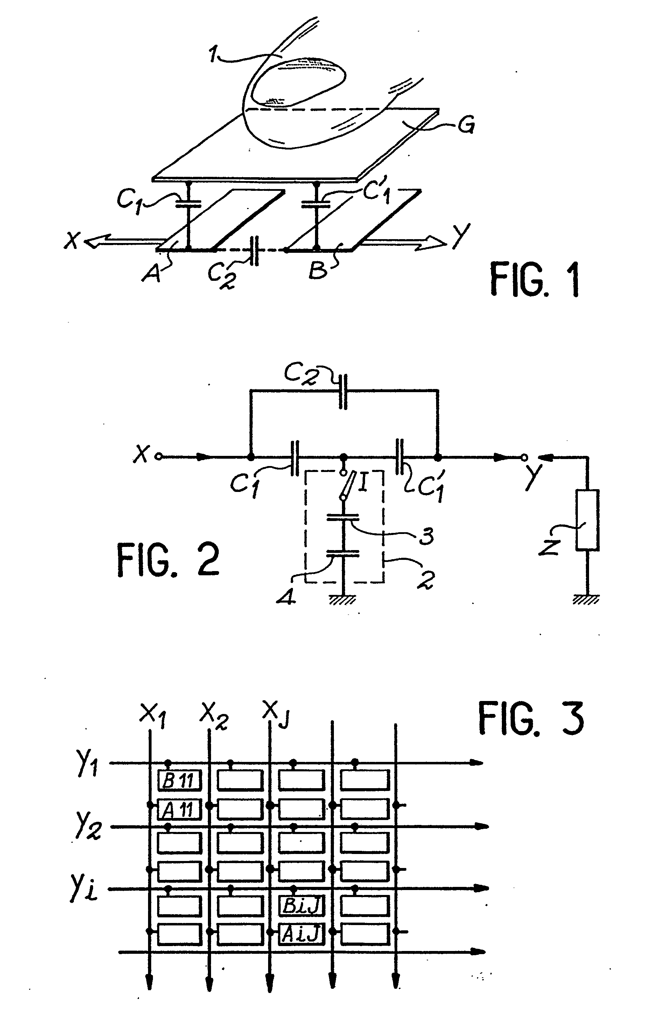

De tels claviers connus comportent généralement, comme on le voit sous forme schématique sur la figure 1, des touches sensibles G associées chacune à un couple d'électrodes sous-jacentes à savoir d'une part une électrode A émettrice excitée séquentiellement par un signal alternatif amené par une ligne émettrice X et d'autre part, une électrode réceptrice B, couplée capacitivement à l'électrode émettrice A par la touche sensible G correspondante. Une ligne réceptrice Y recueille, sur l'électrode réceptrice B, les variations de l'amplitude du signal alternatif sous l'effet de la présence éventuelle du doigt 1 de l'utilisateur situé au voisinage de la touche G.

La figure 2 représente le schéma électrique équivalent d'une telle touche et on y a figuré la ligne X d'entrée, la ligne Y de sortie ainsi que les trois capacités $C_1$, $C'_1$, $C_2$. La capacité $C_1$ représente la capacité entre l'électrode A et l'électrode G, $C'_1$ représente la capacité entre l'électrode G et l'électrode B, et $C_2$ représente le couplage capacitif direct entre l'électrode émettrice A et l'électrode réceptrice B. La présence de l'utilisateur est schématisée par une dérivation 2 entre le point commun aux capacités $C_1$ et $C'_1$ et la masse, cette dérivation comprenant un premier condensateur 3 d'une capacité voisine de 4 picofarads pour représenter le doigt de l'utilisateur et une capacité 4 de l'ordre de 60 picofarads pour représenter la capacité du corps de l'utilisateur par rapport à la terre. L'interrupteur 1 schématise par conséquent la présence ou l'absence du doigt 1 de l'utilisateur sur la touche G. Les données précédentes reposent sur la constatation expérimentale du fait que le corps d'un homme peut être représenté par un corps conducteur d'électricité qui a, par rapport à la terre, une capacité moyenne d'environ 60 picofarads lorsque cet homme porte des chaussures isolantes. Lorsque le doigt d'un utilisateur s'approche de la touche sensible G, il crée avec celle-ci une capacité qui peut varier de 2 à 5 picofarads, notamment selon le fait que ce doigt est ganté ou non, et c'est la présence de cette capacité que le clavier capacitif a pour charge de détecter.

Sur la figure 2, on a représenté également une impédance de charge Z située entre la ligne réceptrice Y et la masse, cette impédance Z représentant schématiquement l'électronique de mesure. Dans les applications connues de tels claviers capacitifs, les deux positions possibles de l'interrupteur 1 sont détectées en mesurant la tension recueillie aux bornes de Z, ou le courant dans l'impédance Z ou encore le déphasage entre le signal émetteur à l'entrée et le signal récepteur à la sortie. De façon générale, la présence du doigt de l'utilisateur correspondant à une dérivation du courant par la ligne 2, se traduit par conséquent par une diminution de la tension sur la ligne Y due au fait que l'impédance augmente entre l'entrée X et la sortie Y. On conçoit ainsi facilement qu'en examinant les variations précédentes sur l'impédance Z à la sortie de la ligne réceptrice Y, on parvienne à déterminer dans chaque cas celle des touches sensibles G du clavier capacitif sur laquelle s'est posé le doigt 1 de l'utilisateur.

On complètera encore la description de l'art connu en donnant quelques précisions sur la façon dont les différentes touches sensibles et électrodes émettrices et réceptrices d'un même clavier capacitif sont connectées à l'extérieur. La façon la plus simple de concevoir ces connexions est de prévoir une ligne émettrice pour chaque électrode réceptrice et une ligne réceptrice pour chaque électrode réceptrice, auquel cas, le schéma de la figure 2 est alors répété autant de fois qu'il y a de touches sensibles G dans le clavier. On conçoit néanmoins que dès qu'il s'agit d'un clavier ayant une certaine importance, cette façon de procéder conduit à un nombre de connexions très élevé, que l'on peut difficilement loger sans problème dans une même structure de clavier. C'est pourquoi, assez souvent, on a recours à une alimentation et à une lecture qui se font sous forme matricielle, les différentes électrodes émettrices A et réceptrices B étant réparties aux sommets d'une matrice rectangulaire comme indiqué sur la figure 3 ci-jointe. Sur cette figure en effet, les différentes électrodes A et B sont réparties en un réseau matriciel comportant des entrées $X_1$, $X_2$,...$X_j$ pour chaque colonne et des sorties $Y_1$, $Y_2$,...$Y_i$ pour chaque ligne. Cette figure 3 se limite au schéma de montage électrique des électrodes émettrices A et réceptrices B, les différentes touches sensibles G n'étant pas figurées et devant être considérées comme situées en dehors du plan de figure audessus de chacun des couples d'électrodes A et B. Pour engendrer et lire les signaux issus du clavier, on utilise une alimentation alternative séquentielle qui arrive sous forme d'impulsions successivement sur chaque colonne $X_j$ alimentant du même coup toutes les électrodes $A_{ij}$ correspondant à une même valeur de j déterminée. On observe alore le signal de sortie en recherchant celle des lignes $Y_i$ qui présente une diminution de signal. Quand cette observation est faite, on sait que c'est la touche (i, j) qui est actionnée si au même moment c'est la colonne $X_{i,j}$ qui est excitée par le train d'impulsions séquentielles alternatif. L'intérêt majeur de ce type de clavier matriciel réside évidemment dans la diminution du nombre de file issus du clavier pour l'alimenter et lire les ordres qu'il reçoit.

A la limite certains claviers capacitifs comportent des électrodes émettrices et réceptrices qui sont réduites à de petites bandes métalliques constituées simplement par les conducteurs de la matrice dont le simple croisement réalise ainsi concrètement les deux électrodes de chaque touche.

Il doit être bien entendu que de tels claviers capacitifs dont les électrodes, à la limite, ne sont plus individualisées, sont également susceptibles de recevoir application du dispositif d'élimination des parasites objet de l'invention; de même, les claviers capacitifs de différents types connus, par exemple à touches enfonçables ou à touches statiques, appartiennent au domaine d'application de l'invention.

L'une des qualités majeures recherchées pour les claviers capacitifs réside dans leur sensibilité, qui doit être la plus élevée possible afin d'obtenir une réponse sans ambiguité à chaque effleurement du doigt d'un utilisateur. Or, un certain nombre d'obstacles empêchent, si l'on ne prend pas de précautions particulières, que ceci soit réalisé.

D'une part, les utilisateurs peuvent être parfois munis de gants isolants qui diminuent fortement la capacité ajoutée par le doigt et d'autre part, si l'on n'y prend pas garde, il est très facile d'influencer simultanément plusieurs touches voisines ce qui peut laisser planer un doute indésirable sur l'intention réelle de l'utilisateur. Par ailleurs, il est nécessaire de pouvoir reconnaître avec le moins de chance d'erreur possible un signal de déclenchement, même en présence d'un bruit de fond parasite relativement élevé. Or, de tels parasites électromagnétiques qui peuvent provenir de sources diverses telles que des émissions de radio ou de télévision, certaines installations à haute tension de l'EDF ou de la SNCF, des charges diverses par influence, etc... peuvent très facilement noyer le signal utile dans un environnement de bruit de fond non négligeable rendant ainsi très aléatoire l'interprétation de l'état de déclenchement d'un clavier capacitif.

A ce sujet, on peut citer le brevet américain US-A-4 145 748 qui décrit un dispositif permettant, dans un clavier à touches capacitives, de sélectionner la touche effectivement effleurée par l'utilisateur, en comparant, à l'aide d'un système multiplexeur, les tensions de sortie obtenues pour chaque touche au signal, mémorisé, de non effleurement, correspondant à chaque touche. Ce dispositif permet par conséquent de déterminer si une touche a été effleurée ou non, mais pas de repérer, parmi plusieurs touches voisines influencées simultanément, celle que l'utilisateur avait effectivement l'intention d'actionner.

La présente invention a pour objet un clavier capacitif à structure antiparasite qui permet de s'affranchir de façon systématique et par des moyens de mise en oeuvre très simple, de tout signal parasite reçu par le clavier.

Ce dispositif d'élimination des parasites dans un clavier capacitif du genre de ceux qui comportent sur leur face extérieure offerte à l'utilisateur une série de touches sensibles associées chacune à un couple d'électrodes sous-jacentes, à savoir, d'une part une électrode émettrice excitée séquentiellement par un signal alternatif amené par une ligne émettrice et, d'autre part, une électrode. réceptrice couplée capacitivement à l'électrode émettrice par la touche sensible correspondante et sur laquelle une ligne réceptrice recueille les variations de l'amplitude du signal alternatif sous l'effet de la présence éventuelle d'un doigt d'un utilisateur sur ladite touche sensible, se caractérise en ce que les signaux en provenance de chaque ligne réceptrice sont envoyés dans un soustracteur qui établit la différence avec le signal présent sur une ligne de référence située dans le clavier et fournit, en sortie un signal d'exploitation exempt de la composante électromagnétique parasite ayant pu pénétrer dans la structure du clavier.

Le fonctionnement·du dispositif objet de l'invention repose sur le fait que la surface des claviers capacitifs généralement utilisés est suffisamment restreinte pour que l'on puisse admettre qu'un parasite électromagnétique en provenance de l'extérieur atteint pratiquement toutes les électrodes du clavier de façon simultanée. De cette façon, si l'on établit la différence entre le signal présent sur une ligne émettrice et le signal présent au même instant sur une ligne de référence située dans le clavier, on obtient finalement en sortie d'un soustracteur un signal d'exploitation exempt de toute composante électromagnétique parasite.

La ligne de référence utilisée peut être, selon l'invention, de nature diverse, mais c'est toujours soit une ligne réceptrice elle-même faisant partie de la structure, soit une combinaison de telles lignes. Ceci est une différence essentielle par rapport à la structure décrite dans le document FR-A-2.397.696, dans laquelle, pour surveiller l'état d'allumage ou d'extinction des sommets de la matrice d'un panneau électroluminescent, on a recours à une ligne de référence independante de cette matrice et qui ne fonctionne pas comme les autres. Par ailleurs, il s'agit, dans ce brevet, de compenser une erreur systématique interne du panneau d'affichage, due au courant de polarisation traversant la couche mince électroluminescente, et qui constitue un seuil de référence variable. Dans la présente invention au contraire, on utilise la structure existante elle-même pour éliminer des parasites externes et aléatoires.

En effet, dans un premier mode de mise en oeuvre, cette ligne de référence n'est autre qu'une deuxième ligne réceptrice du clavier capacitif luimême.

Dans un deuxième mode de réalisation du dispositif objet de l'invention, la ligne de référence est réunie à un circuit qui exploite un signal résultant de la combinaison d'une pluralité de signaux recueillis simultanément sur plusieurs lignes réceptrices du clavier. On obtient ainsi un signal parasite éventuel de référence correspondant à la "valeur moyenne" des signaux parasites reçus sur les lignes réceptrices en question.

Dans une autre variante de réalisation du clavier objet de l'invention, les deux lignes réceptrices de lecture et de référence sont deux lignes réceptrices adjacentes d'un clavier exploité selon une structure matricielle. Cette façon de procéder possède l'intérêt de rechercher le signal de référence dans le voisinage le plus immédiat de la ligne réceptrice concernée par un signal d'exploitation, ce qui augmente les chances de détection d'un signal parasite.

Selon un mode de mise en oeuvre du dispositif objet de l'invention, chaque ligne réceptrice comporte à la sortie un amplificateur opérationnel monté en intégrateur de courant, possédant un coefficient d'amplification en boucle ouverte élevé, de l'ordre de 10.000 à 50.000, et bouclé sur luimême par un circuit de contre-réaction RC. Chaque amplificateur est suivi de deux circuits de seuils $\pm$ Vo dont les sorties sont reliées à l'entrée d'un circuit OU délivrant un signal caractéristique de la présence d'un parasite d'amplitude > Vo, que l'on utilise pour bloquer le fonctionnement du clavier pendant toute la durée du parasite.

Cette variante du dispositif d'élimination des parasites est très utile pour s'affranchir des parasites de très haute tension (plusieurs milliers de volts par exemple) qui peuvent être produits par des charges electrostatiques ou des coupures de courant à haute tension. De tels parasites d'amplitude très élevée sont dangereux pour l'électronique du clavier qu'ils risquent de saturer, voire même de détruire, et ils provoquent des déclenchements intempestifs.

Selon une autre variante intéressante de l'invention, pour rechercher en outre la touche fournissant le plus grand signal lors d'une détection de déclenchement, la tension électrique proportionnelle à la variation de capacité provoquée par la présence du doigt d'un utilisateur près de la touche effleurée aux tensions éventuelles provenant d'autres touches voisines de façon telle qu'une tension de plus grande amplitude éventuellement décelée soit automatiquement mémorisée à la place de la précédente.

Cette façon de procéder permet de résoudre les ambiguités qui peuvent se présenter lorsqu'un utilisateur a, par inadvertance, effleuré plusieurs touches à la fois.

A cet effet, le clavier objet de l'invention comprend en outre un dispositif d'exploration séquentielle délivrant en sortie un signal analogique correspondant à chaque touche successivement, un amplificateur de ce signal, une mémoire analogique pour ledit signal amplifié suivie d'un comparateur de tension, une mémoire d'adresse recevant les coordonnées de chaque touche examinée par le dispositif d'exploration séquentielle et une ligne de commande d'un premier interrupteur situé entre la sortie de l'amplificateur et la mémoire analogique et d'un deuxième interrupteur reliant le dispositif d'exploration séquentielle et la mémoire d'adresse, ladite ligne de commande étant sous les ordres du signal de sortie du comparateur.

Selon l'invention, le clavier capacitif antiparasite peut enfin avoir une structure perfectionnée dans laquelle il comporte deux couches isolantes assemblées par collage, dont la première porte sur sa face externe les touches sensibles 0 et, partout ailleurs, un blindage conducteur mis à la masse, et dont la seconde porte, sur sa face la plus superficielle les électrodes et les lignes réceptrices, des électrodes de séparation et leurs lignes d'alimentation, et, sur sa face la plus profonde, les lignes et les électrodes émettrices, des électrodes de séparation et un blindage conducteur mis à la masse.

Dans cette structure, l'action des deux blindages supérieur et inférieur mis a la masse renforce la protection contre les parasites externes déjà réalisée par la présence de la ligne de référence, et les électrodes de séparation, mises à la masse, annule pratiquement la capacité parasite de couplage direct entre les électrodes A et B qui sans cela a tendance à diminuer le signal utile du clavier.

De toute façon, l'invention sera mieux comprise en se référant à la lecture qui suit de la description de plusieurs exemples de mise en oeuvre du dispositif d'élimination des parasites. Cette description sera faite en se référant aux figures 4 à 8 ci-jointes parmi lesquelles:

- la figure 4 montre le schéma de principe du dispositif selon l'invention dans le cas où la ligne de référence utilisée est issue d'un circuit réalisant la combinaison de plusieurs signaux recueillis sur plusieurs lignes réceptrices,

- la figure 5 illustre le dispositif objet de l'invention appliqué au cas où les deux lignes réceptrices utilisées pour effectuer la soustraction des signaux sont deux lignes réceptrices adjacentes d'une même structure matricielle,

- la figure 6 montre le schéma du dispositif électronique d'élimination des parasites à haute tension d'amplitude supérieure à un seuil déterminé,

- la figure 7 illustre le schéma de principe du dispositif mis en oeuvre pour repérer parmi plusieurs touches actionnées par un utilisateur celle qui fournit le signal le plus élevé,

- la figure 8 représente une réalisation préférentielle de clavier capacitif antiparasite comportant deux blindages protecteurs.

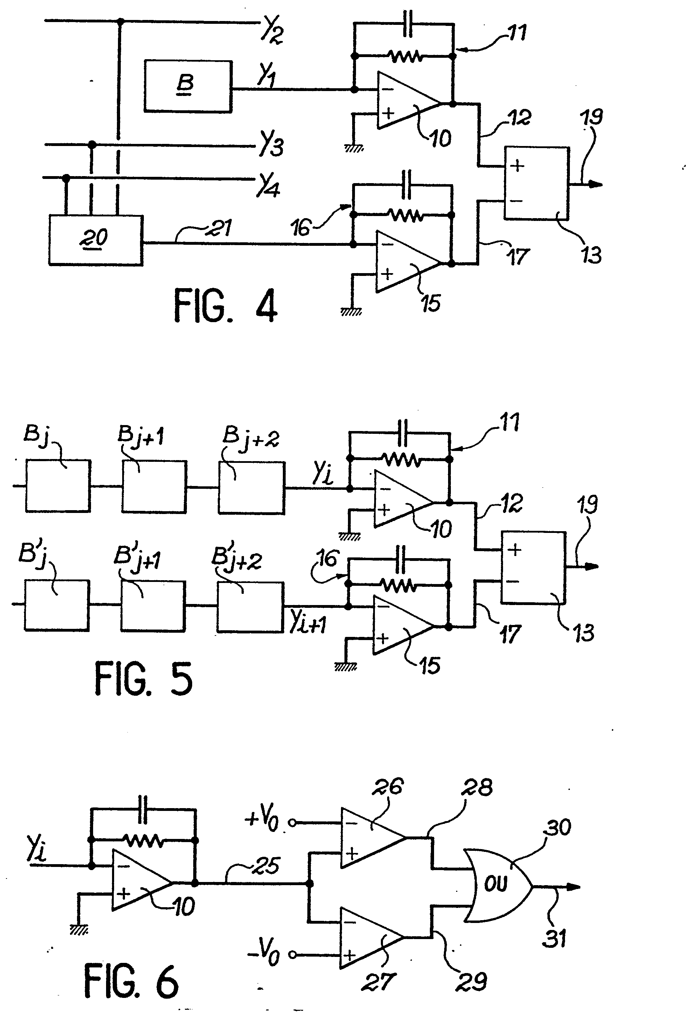

Sur la figure 4, on a représenté une électrode réceptrice B et la ligne réceptrice correspondante $Y_1$ alimentant l'amplificateur opérationnel 10. Cet amplificateur opérationnel 10 est un amplificateur monté en intégrateur de courant et bouclé sur lui-même par le circuit de contre-réaction 11 du type RC. La ligne réceptrice $Y_1$ pénètre dans l'amplificateur de tension 10 par l'entrée négative comme le circuit de contre-réaction 11. L'entrée positive est à la masse. La sortie 12 de l'amplificateur 10 est connectée à l'une des entrées d'un soustracteur 13. Selon l'invention, une ligne de référence 21 située dans le clavier est connectée à l'entrée négative d'un deuxième amplificateur opérationnel 15 également monté en intégrateur de courant et bouclé sur lui-même par un circuit de contre-réaction 16. La sortie 17 de l'amplificateur opérationnel 15 est reliée à la seconde entrée du soustracteur 13.

Dans le mode de mise en oeuvre de la figure 4, la ligne $Y_1$ et l'électrode réceptrice B alimentent l'amplificateur de tension 10 et le signal de référence est élaboré à partir d'un circuit 20 qui recueille en en faisant la moyenne les signaux présents sur trois autres lignes réceptrices $Y_2$, $Y_3$ et $Y_4$. C'est finalement cette moyenne de signaux qui par l'intermédiaire de la ligne 21 alimente le deuxième amplificateur de tension 15. Le fonctionnement du dispositif décrit schématiquement sur la figure 4 est facile à comprendre: le signal de sortie que l'on désire exploiter sur la ligne réceptrice $Y_1$ peut être éventuellement mêlé avec une composante représentant un parasite électromagnétique qui est alors également présent sur la ligne de référence 21 avec la même intensité. Après amplification dans les amplificateurs 10 et 15 et soustraction dans le soustracteur 13, cette composante parasite s'élimine et il ne subsiste à la sortie 19 du soustracteur 13 que le seul signal utile d'exploitation du clavier.

Le mode de mise en oeuvre de la figure 5 est relatif au dispositif selon l'invention appliqué au cas d'une exploitation du clavier à l'aide d'une structure matricielle. On a représenté à cet effet deux lignes réceptrices $Y_i$ et $Y_{i+1}$ alimentant respectivement les deux mêmes amplificateurs de tension 10 et 15 que dans l'exemple précédent de la figure 4. On voit également sur cette figure un certain nombre d'électrodes réceptrices au nombre de six et référencées pour la ligne $Y_i$, $B_j$, $B_{j+1}$ et $B_{j+2}$ et, pour la ligne $Y_{i+1}$, $B'_j$, $B'_{j+1}$ et $B'_{j+2}$. Le fonctionnement du dispositif de la figure 5 est comparable à celui de la figure 4 précédente en ce sens que les signaux de sortie présents sur les lignes réceptrices $Y_i$ et $_{i+1}$ contiennent éventuellement la même composante parasite qui après amplification et soustraction est totalement éliminée à la sortie 19 du système. Dans ce mode de mise en oeuvre, la ligne de référence utilisée étant la ligne réceptrice $Y_{i+1}$ directement adjacente à la ligne de lecture $Y_i$, on est assuré de réunir le maximum de chances pour qu'un signal parasite en provenance de l'extérieur ait influencé de façon pratiquement identique les deux séries d'électrodes émettrices $B_j$ et $B'_j$.

Sur la figure 6, on a représenté une partie d'un dispositif selon l'invention permettant de s'affranchir des conséquences fâcheuses de l'apparition d'un signal à haute tension sur l'une des lignes réceptrices $Y_i$ d'un clavier capacitif. Des parasites de plusieurs milliers de volts peuvent en effet être produits par des charges électrostatiques ou par des coupures de courant à haute tension comme on en trouve au voisinage des lignes de trolley-bus ou de trains électriques. De tels parasites de grande amplitude sont dangereux pour l'électronique du clavier et peuvent provoquer des déclenchements intempestifs indésirables. Le dispositif de la figure 6 permet de pallier ces dangers de la façon suivante. On voit sur cette figure 6 une ligne réceptrice $Y_i$ connectée comme dans les deux exemples précédents à l'entrée négative d'un amplificateur opérationnel 10 monté en intégrateur de courant et bouclé sur lui-même par son circuit de contre-réaction 11 de type RC. Le signal présent à la sortie de cet amplificateur 10 est amené par une ligne 25 à l'entrée commune de deux circuits de seuils 26 et 27 montés en opposition et dont le premier 26 est polarisé à une tension $+V_o$ et le second 27 est polarisé à une tension $-V_o$. Les sorties 28 et 29 de ces circuits à seuils 26 et 27 sont reliées à l'entrée d'un circuit OU 30 qui délivre en sortie sur la ligne 31 un signal indiquant la présence d'un parasite d'amplitude positive ou négative supérieure à $V_o$. Le signal alors présent sur la ligne 31 peut être utilisé facilement pour maintenir bloquée l'électronique de lecture de déclenchement du clavier tant que ce parasite existe. Dans des réalisations courantes de clavier capacitif, le signal normal présent sur la ligne $Y_i$ est de l'ordre de $\pm$ 200 mV au maximum. Il suffit dans ce cas que les circuits de seuils 26 et 27 soient réglés pour détecter des dépassements au-delà de 1 V environ pour que l'on soit certain que des tensions de cet ordre sont dues à l'action de parasites électriques externes.

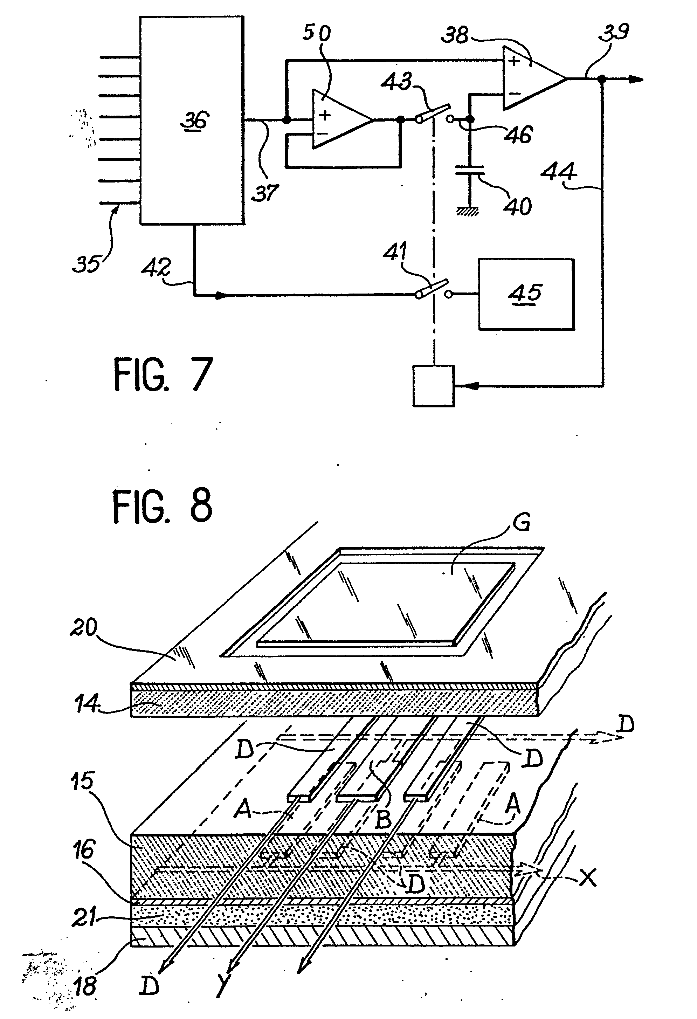

Le dispositif de la figure 7 montre un schéma permettant de rechercher au moment de l'arrivée d'un ordre de déclenchement du clavier selon l'invention, la touche fournissant le plus grand signal. Ceci est en effet important dans tous les cas où un utilisateur ayant influencé de façon différente plusieurs touches sensibles voisines, il devient nécessaire de connaître avec précision son intension réelle. Dans cette realisation, les signaux d'exploitation de plusieurs lignes réceptrices $Y_i$ parviennent en 35 dans un dispositif d'exploration séquentielle 36 lequel délivre sur une ligne 37 de façon successive les signaux présents éventuellement sur les différentes lignes réceptrices 35. Le signal présent sur la ligne 37 est envoyé dans un ensemble amplificateur opérationnel adaptateur de tension 50 muni de sa boucle de contreréaction 11 ainsi qu'a la première entrée d'un comparateur 38 qui délivre en sortie 39 une tension Vs. Le dispositif est complété par deux mémoires, à savoir une mémoire analogique 40 placée en dérivation entre la masse et la deuxième entrée 41 du comparateur 38 et une mémoire d'adresse 45 qui par l'intermediaire d'un premier interrupteur 41 et d'une ligne 42 reliés au dispositif d'exploration séquentielle 36 permet d'enregistrer le cas échéant l'adresse de chacune des touches sensibles sur lesquelles on perçoit un signal. Un second interrupteur 43 permet de relier la sortie de l'amplificateur opérationnel 50 et l'entrée 46 du comparateur 38; les deux interrupteurs 41 et 43 sont susceptibles de fonctionner simultanément sous l'effet d'un ordre reçu à partir de la sortie 39 du comparateur 38 par l'intermédiaire de la ligne 44.

Le fonctionnement du dispositif de la figure 7 est le suivant: pour chaque touche du clavier analysée, le traitement électronique du dispositif d'exploration séquentielle 36 fournit à la fois une tension proportionnelle sur la ligne 37 à la variation de capacité provoquée par la présence du doigt d'un utilisateur sur la touche en question ainsi que l'adresse précise de cette touche. La valeur de la tension électrique recueillie sur la touche correspondante est mise en mémoire sous forme analogique dans la mémoire 40 en même temps que son adresse correspondante dans la mémoire 45. Lorsque l'on passe ensuite à l'examen de la touche suivante, on effectue à l'aide du comparateur 38 la comparaison entre la tension mise dans la mémoire 40 pour la touche précédente et la nouvelle tension en cours de lecture. Le comparateur 38 fait la différence et si cette différence est positive, c'està-dire s'il existe un signal Vs positif sur la ligne 39, un ordre de transfert est émis par le comparateur 38 sur la ligne 44 qui commande la fermeture des deux interrupteurs 41 et 43 pour mettre dans la mémoire 40 la nouvelle tension lue à la place de la précédente et, dans la mémoire 45, la nouvelle adresse de la touche sensible en cours d'exploration. Lorsqu'on a ainsi analysé plusieurs touches de façon successive, on est certain d'avoir repéré celle qui fournissait le plus grand signal en amplitude, c'est-à-dire celle que, selon le plus haut degré de vraisemblance, l'utilisateur désirait actionner.

Sur la figure 8, on peut voir, en perspective éclatée, une réalisation préférentielle d'une partie du clavier capacitif selon l'invention. On voit sur cette figure 8 que le clavier est constitué de deux couches isolantes supérieure 14 et inférieure 15.

La couche 14 porte un blindage protecteur conducteur 20 autour des touches sensibles G et est de préférence transparente;

La deuxième couche 15 (ou circuit imprimé) porte les différentes électrodes émettrices-réceptrices et de séparation réparties comme suit. Sur la face externe de ladite couche 15, on trouve les électrodes de séparation D associées à l'électrode réceptrice B et aux lignes réceptrices Y$_i$. Ces électrodes D ont pour but de diminuer le couplage direct entre les électrodes A et B. Sur la face interne de la couche isolante 15 on trouve les électrodes émettrices A avec la ligne émettrice X$_i$ et une paire d'électrodes de séparation D reliées à une ligne D de connexion électrique de ces mêmes électrodes. Une étiquette 16 est éventuellement placée sous la couche isolante 15 pour indiquer la fonction de la touche G; une couche isolante 21 et un blindage métallique conducteur 18 mis à la masse comme le blindage 20, terminent la structure vers le bas. L'ensemble des couches isolantes 14 et 15 de l'étiquette 16, de l'isolant 21 et du blindage 18 est maintenu assemblé par collage. Dans une structure conforme à la figure 8, les parasites externes ne peuvent pénétrer que par les touches (G) ce qui limite considérablement leur accés; de toute façon, la combinaison des effets de cette structure avec ceux de la ligne de référence 21 de la figure 4 assure une protection quasi totale contre les parasites extérieurs et un rapport signal/bruit excellent.

## Revendications

1. Dispositif d'élimination des parasites dans un clavier capacitif du genre de ceux qui comportent sur leur face extérieure offerte à l'utilisateur une série de touches sensibles (G) associées chacune à un couple d'électrodes sous-jacentes, à savoir d'une part une électrode émettrice (A) excitée séquentiellement par un signal alternatif amené par une ligne émettrice (X) et d'autre part, une électrode réceptrice (B) couplée capacitivement à l'électrode émettrice par la touche sensible correspondante et sur laquelle une ligne réceptrice (Y) recueille les variations de l'amplitude du signal alternatif sous l'effet de la présence éventuelle d'un doigt (1) d'un utilisateur sur ladite touche sensible, caractérisé en ce que les signaux en provenance de chaque ligne réceptrice sont envoyés dans un soustracteur (13) qui établit la différence avec le signal présent sur une ligne de référence (21) située dans le clavier et fournit, en sortie, un signal d'exploitation exempt de la composante électromagnétique parasite ayant pu pénétrer dans la structure du clavier.

2. Dispositif selon la revendication 1, caractérisé en ce que la ligne de référence (21) est une deuxième ligne réceptrice (Y).

3. Dispositif selon la revendication 1, caractérisé en ce que ladite ligne de référence (21) est réunie à un circuit (20) réalisant une combinaison d'une pluralité de signaux recueillis dans plusieurs lignes réceptrices (Y$_2$, Y$_3$, Y$_4$).

4. Dispositif selon la revendication 2, caractérisé en ce que les deux lignes réceptrices (Y) sont deux lignes réceptrices adjacentes (Y$_i$, Y$_{i+1}$) d'une structure matricielle.

5. Dispositif selon la revendication 1, caractérisé en ce que chaque ligne réceptrice (Y) comporte à la sortie un amplificateur opérationnel (10) monté en intégrateur de courant, bouclé sur lui-même par un circuit de contre-réaction et suivi de deux circuits de seuils $\pm$ Vo (26, 27) dont les sorties sont reliées à l'entrée d'un circuit OU (30) délivrant un signal caractéristique de la présence d'un parasite d'amplitude > Vo, que l'on utilise pour bloquer le fonctionnement du clavier pendant toute la durée du parasite.

6. Clavier capacitif selon la revendication 1, caractérisé en ce qu'il comprend en outre un dispositif d'exploration séquentielle (36) délivrant en sortie un signal analogique correspondant à chaque touche successivement, un amplificateur (50) de ce signal, une mémoire analogique (40) pour ledit signal amplifié suivie d'un comparateur de tension (38), une mémoire d'adresse (45) recevant les coordonnées de chaque touche examinée par le dispositif d'exploration séquentielle (36) et une ligne de commande (44) d'un premier interrupteur (43) situé entre la sortie de l'amplificateur (50) et la mémoire analogique (40) et d'un deuxième interrupteur (41) reliant le dispositif d'exploration séquentielle (36) et la mémoire d'adresse (45), ladite ligne de commande (44) étant sous les ordres du signal de sortie du comparateur (38).

7. Clavier capacitif selon la revendication 1, caractérisé en ce qu'il comporte deux couches isolantes assemblées par collage, dont la première (14) porte sur sa face externe les touches sensibles G et, partout ailleurs, un blindage conducteur (20) mis à la masse, et dont la seconde (15) porte, sur sa face la plus superficielle les électrodes (B) et les lignes (Y) réceptrices, des électrodes de séparation (D) et leurs lignes d'alimentation, et, sur sa face la plus profonde, les lignes (X) et les électrodes (A) émettrices, des électrodes de séparation (D) et un blindage conducteur (18) mis à la masse.

**Patentansprüche**

1. Einrichtung zum Beseitigen von Störungen bei einem kapazitiven Tastenfeld des Typs, der auf seiner dem Benutzer zugewandten Außenfläche eine Reihe von Berührtasten (G) aufweist, die jeweils einem Paar darunterliegender Elektroden zugeordnet sind, nämlich einerseits einer Sendeelektrode (A), die sequentiell mit einem von einer Sendeleitung (X) gelieferten Wechselsignal erregt wird, und andererseits einer Empfangselektrode (B), die über die entsprechende Berührtaste kapazitiv an die Sendeelektrode gekoppelt ist, und an der eine Empfangsleitung (Y) Amplitudenschwankungen des Wechselsignals, die hervorgerufen werden durch das eventuelle Vorhandensein eines Fingers (1) eines Benutzers auf der Berührtaste, empfängt, dadurch gekennzeichnet, daß die von jeder Empfangsleitung stammenden Signale einem Subtrahierglied (13) zugeleitet werden, welches die Differenz bildet zu einem Signal auf einer in dem Tastenfeld gelegenen Bezugsleitung (21), und am Ausgang ein Nutzsignal liefert, welches frei ist von der elektromagnetischen Störkomponente, die in die Struktur des Tastenfeldes hat eindringen können.

2. Einrichtung nach Anspruch 1, dadurch gekennzeichnet, daß die Bezugsleitung (21) eine zweite Empfangsleitung (Y) ist.

3. Einrichtung nach Anspruch 1, dadurch gekennzeichnet, daß die Bezugsleitung (21) an eine Schaltung (20) angeschlossen ist, die eine Kombination mehrerer Empfangssignale in mehrere Empfangsleitungen ($Y_2$, $Y_3$, $Y_4$) bildet.

4. Einrichtung nach Anspruch 2, dadurch gekennzeichnet, daß die zwei Empfangsleitungen (Y) zwei benachbarte Empfangsleitungen ($Y_i$, $Y_{i+1}$) einer Matrixstruktur sind.

5. Einrichtung nach Anspruch 1, dadurch gekennzeichnet, daß jede Empfangsleitung (Y) am Ausgang einen als Stromintegrator geschalteten Operationsverstärker (10) aufweist, der eine Rückkoppelungsschleife enthält, und an den sich zwei Schwellenwertschaltungen (26, 27) für Schwellenwerte $\pm$ Vo anschließen, deren Ausgänge an den Eingang eines ODER-Glieds (30) angeschlossen sind, der ein für das Vorhandensein einer Störamplitude > Vo kennzeichnendes Signal liefert, das dazu verwendet wird, die Funktion des Tastenfeldes während der gesamten Dauer der Störung zu sperren.

6. Kapazitives Tastenfeld nach Anspruch 1, dadurch gekennzeichnet, daß es außerdem enthält: Eine sequentiell arbeitende Auswerteschaltung (36), die am Ausgang ein Analogsignal liefert, welches jeder aufeinanderfolgenden Taste entspricht, einen Signalverstärker (50), einen Analogspeicher (40) für das verstärkte Signal, gefolgt von einem Spannungsverstärker (38), einen Adreßspeicher (45), der die Koordinaten jeder von der sequentiell arbeitenden Auswerteschaltung (36) untersuchten Taste empfängt, und eine Steuerleitung (44) für einen ersten Unterbrecher (43), der zwischen dem Ausgang des Verstärkers (50) und dem Analogspeicher (40) liegt, sowie einen zweiten Unterbrecher (41), der die sequentiell arbeitende Auswerteschaltung (36) mit dem Adreßspeicher (45) verbindet, und daß die Steuerleitung (44) von dem Ausgangssignal des Vergleichers (38) mit Steuerbefehlen beaufschlagt wird.

7. Kapazitives Tastenfeld nach Anspruch 1, dadurch gekennzeichnet, daß es zwei durch Verkleben verbundene Isolierschichten enthält, von denen die erste (14) auf der Außenfläche die Berührtasten G und außerdem einen auf Masse gelegten Abschirmleiter (20) trägt, und von denen die zweite (15) auf ihrer am weitesten oben gelegenen Fläche die Empfangselektroden (B) und -leitungen (Y), Trennelektroden (D), sowie deren Versorgungsleitungen trägt, und auf der am weitesten unten gelegenen Fläche die Sendeleitungen (X) und -elektroden (A), Trennelektroden (D) und einen auf Masse gelegten Abschirmleiter (18) trägt.

## Claims

1. Device for eliminating interference in a capacitive keyboard of the type comprising on the external face available to the user a series of sensitive keys (G) each associated with a pair of subjacent electrodes, these being, on the one hand, a transmitting electrode (A) sequentially excited by an alternating signal supplied by a transmitting line (X) and, on the other hand, a receiving electrode (B) capacitively coupled to the transmitting electrode by the corresponding sensitive key and on which a receiving line (Y) collects the amplitude variations of the alternating signal due to the effect of the possible presence of a finger (1) of a user on the said sensitive key; characterized in that the signals originating from each receiving line are sent into a subtractor (13) which establishes the difference with respect to the signal present on a reference line (21) located in the keyboard and supplies at its output a useful signal free from the electromagnetic interference component which has been able to penetrate into the structure of the keyboard.

2. Device according to Claim 1, characterized in that the reference line (21) is a second receiving line (Y).

3. Device according to Claim 1, characterized in that the said reference line (21) is linked to a circuit (20) combining a plurality of signals collected in several receiving lines (Y2, Y3, Y4).

4. Device according to Claim 2, characterized in that the two receiving lines (Y) are two adjacent receiving lines (Yi, Yi + 1) in a matrix structure.

5. Device according to Claim 1, characterized in that each receiving line (Y) includes at the output an operational amplifier (10) connected as current integrattor, connected back to itself by a negative feedback circuit and followed by two threshold circuits ± Vo (26, 27) the outputs of which are linked to the input of an OR circuit (30) supplying a signal characteristic of the presence of an interference having an amplitude > Vo, which is used for inhibiting the keyboard operation for the entire duration of the interference.

6. Capacitive keyboard according to Claim 1, characterized in that it also comprises a sequential scanning device (36) supplying at its output an analog signal successively corresponding to each key, an amplifier (50) for this signal, an analog storage device (40) for the said amplified signal, followed by a voltage comparator (38), an address memory (45) receiving the coordinates of each key examined by the sequential scanning device (36) and a control line (44) of a first switch (43) located between the output of the amplifier (50) and the analog storage device (40) and of a second switch (41) linking the sequential scanning device (36) and the address memory (45), said control line (44) being under control of the output signal of the comparator (38).

7. Capacitive keyboard according to Claim 1, characterized in that it comprises two insulating layers cemented together, the first one of which (14) carries on its external face the sensitive keys G and, in all other locations, a shielding conductor (20) connected to earth, and the second one of which (15) carries on its face closest to the surface the receiving electrodes (B) and lines (Y), the separating electrodes (D) and their feed lines, and on the lowermost face, the transmitting lines (X) and electrodes (A), the separating electrodes (D) and a shielding conductor (18) connected to earth.

FIG. 1

FIG. 2

FIG. 3

FIG. 4

FIG. 5

FIG. 6

FIG. 7

FIG. 8